# EUROPEAN PATENT APPLICATION

(11) **EP 2 690 647 A1**
(43) Date of publication of application: **29.01.2014**
(21) Application number: 13003719.5
(22) Date of filing: 24.07.2013
(51) Int. Cl.: H01J 37/22, G01N 23/225

(54) **System and method for measuring angular luminescence in a charged particle microscope**

(30) Priority: 26.07.2012 US 201213558948
(71) Applicant: Stowe, David, Reading, Berkshire RG4 6LS (GB); Galloway, Simon Andrew, Oxford, Oxon OX2 0BZ (GB); Parsons, James, Yeovil BA21 3JY (GB)
(72) Inventor: Stowe, David, Reading, Berkshire RG4 6LS (GB); Galloway, Simon Andrew, Oxford, Oxon OX2 0BZ (GB); Parsons, James, Yeovil BA21 3JY (GB)
(74) Representative: Beier, Ralph

(57) **Abstract**

Cathodoluminescence performed in the scanning electron microscope brings the advantage of localized excitation of individual microscopic structures. When luminescent structures are characterized, the intensity, wavelength, polarization and angular emission of the luminescence are all of interest. The invention provides an apparatus for determining the angular distribution of the radiated light, and in particular provides the user with rotational symmetry which is essential for the principle of measurement. This is compatible with additional polarization and spectral bandpass filtering methods used to characterize the luminescence and understand the specimen.

## Description

### FIELD OF THE INVENTION

This invention relates to detection of cathodoluminescence in a charged particle microscope.

### BACKGROUND OF THE INVENTION

This invention addresses the measurement of the angular distribution of emitted luminescence produced by a sample in an electron microscope in one image over a large solid angle. Such measurements were performed in various ways in the prior art. For example, in one approach, the 2D detector is orthogonal and external to the electron microscope. In this approach, extraction of the light requires the use of a 90 degree off-axis parabolic mirror. Coenen et al., Angle-resolved Cathodoluminescence Spectroscopy, Applied Physics Letters 99, 143101 (2011). All references cited herein are incorporated by reference.

Yamamoto and co-workers developed a technique using the same geometry as Coenen. In Yamamoto, however the angular distribution of CL was measured by translating a pinhole in front of a CCD camera, thus collecting point-by-point angular data. This approach was to screen out rays which were not in focus at the detector, and investigate the polarization of the luminescence. Yamamoto et al., "Gao and Mie Plasmons in Individual Silver Nanospheres near a Silver Surface" 11 Nano Letters 91-95 (2011).

### SUMMARY OF THE INVENTION

In an aspect of the invention there is disclosed a system for measurement of angular cathodoluminescence radiation patterns from a specimen in a charged particle microscope. The system includes: a rotationally symmetric concave mirror having a rotational axis and a hole at the intersection of the rotational axis and the mirror; a charged particle source, directing charged particles through hole toward the specimen; and an image sensor for recording a two-dimensional image. In this embodiment, the specimen is located between the mirror and the sensor at the focal point of the mirror and the cathodoluminescence is directed by the mirror to the sensor. The two dimensional image is mapped to polar angles of radiation emission from the specimen.

In a further aspect of the invention just described, there is a filter placed between the sample and said sensor. In a further embodiment the filter includes e at least one of a spectral bandpass filter and an actuated polarizing filter

In a further aspect of the invention, the mirror is inserted into the microscope by a remote fixing post attached to a chamber wall of the microscope. In a further aspect of the invention, the mirror is actuated by a linear actuator. In a further aspect of the invention, the mirror is parabolic. In a further aspect, the system includes an eucentric rotation stage. In a further aspect, the invention, the system includes an eucentric tilt stage.

In another aspect of the invention there is disclosed a method of measuring angular distribution of radiated cathodoluminescence from a specimen in a charged particle microscope. The method includes the steps of: providing a rotationally symmetric concave mirror having a rotational axis and a hole at the intersection of the rotational axis and the mirror; locating the specimen at the focal point of the mirror between the mirror and an image sensor for recording a two-dimensional cathodoluminescence image; directing charged particles through the hole toward the specimen; and relating the two dimensional cathodoluminescence image to polar angles of radiation emission from the specimen.

### DESCRIPTION OF THE DRAWINGS

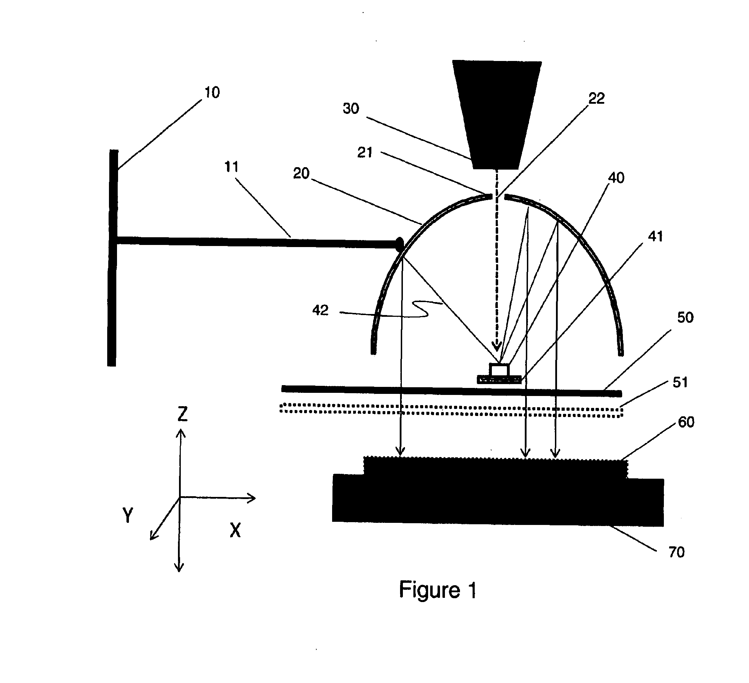

Fig. 1. is a system diagram of an exemplary system for measuring angular resolved luminescence.

### DETAILED DESCRIPTION

An embodiment of the invention is described as follows with respect to Figure 1. A sample 40 is illuminated with charged particles 22 from a pole piece 30. In this embodiment, the system is a Scanning Electron Microscope (SEM). There is a concave mirror 20 suspended above the sample, in this case attached to the chamber wall 10 by an actuator arm 11. A hole 21 in the mirror 20 is centered about the particle beam 22 to allow the beam to pass through the mirror to the sample 40. The sample emits cathodoluminescence (CL) at a variety of angles (e.g. 42). The CL is reflected to an image sensor 60. In various embodiments, spectral bandpass filters 50 and actuated polarization filters are placed above the image sensor 60. The image sensor can be cooled by a cooling plate 70 using standard thermoelectric or cryogenic cooling technology to increase the signal to noise ratio of the image sensor. The sample is carried on a sample holder 41, which is designed to minimize the amount of reflected CL that is obstructed before hitting the image sensor 60. The sample supporting platform is designed so as not to interfere with the electromagnetic modes of the structure being measured. The sample is adjusted in the Z axis to be at the focal point of the concave mirror. If the mirror is parabolic, then the light reflected from the mirror is collimated (with the sample at the focus) and is easily imaged on the sensor and emission angle determined. Specimen charging can be mitigated by grounding or else use of low vacuum, or localized gas injection conditions.

The mirror is preferably a rotationally symmetric parabolic mirror and will ideally be mounted on the SEM chamber port wall 10. This facilitates actuated insertion and retraction with fine scale control. In an alternative embodiment the mirror is mounted to the pole piece of the SEM.

It is critical that the mirror has a well-defined optical focus and that the electron beam irradiated part of the specimen is at this precise location. Variations in either the surface roughness or curvature of the mirror from an ideal parabola by even a fraction of a wavelength of light will cause a phase related interference pattern on the detector image. This will impair the ability to deconvolve the desired angular information.

The spatial resolution of the device is related to focused electron beam spot size, the electromagnetic modes supported by the specimen and the quality of the focusing in the experiment.

Bandpass filtering 50 can be incorporated into the parallel light path between the mirror and the detector. Polarization filtering 60 can also be inserted instead or as well as bandpass filtering into the same light path.

The novel geometry of the collection optics and detector position provides access to a significantly larger solid angle than prior art devices which use an open off-axis parabola. Close to 2pi steradians solid angle is exposed in the present invention as opposed to 1.2 to 1.4pi steradians in prior art. Other mirror geometries are possible as long as they are rotationally symmetric and the specimen resides at a focal point. For example if a hemispherical mirror is employed, then a different image will be recorded and a different algorithm will be employed to deduct the angular luminescence.

The symmetry of the apparatus precludes the need to rotate and reposition the specimen with respect to the measurement system. However rotation of the stage 41 may still be desirable for some embodiments.

The algorithm to convert the recorded image on the detector into an angular emission profile is simpler than that required where there is no 360 rotation symmetry and the emitted light is parallel to the surface normal of the specimen.

Non-transparent specimens cast a shadow over the detector, so utilization of larger specimens will require scaling of the distances, mirror and detector hardware. This is possible without losing resolution or sensitivity. This is within the limits of the Z space available on the stage.

The electron beam focus can be kept stationary with different parts of a specimen irradiated by translating the specimen on a stage independent of the mirror optics. For a flat specimen, this can be achieved without altering the focus of the device.

The mirror has precision adjustment in the (X,Y) plane orthogonal to the axis of the column and zoom (working distance) axis of the SEM. This is because the mirror's rotationally symmetric axis and electron beam aperture should be concentric with the zoom axis of the SEM.

A test specimen with known uniformity of angular emission can be used to align the system.

The 2D detector is mounted on the SEM stage. In an embodiment, this is a modular design which is installed when the chamber is vented or, in a further embodiment, attached to the stage using an airlock. The signal from the detector, either processed or unprocessed depending on the design is be fed outside the SEM chamber through an hermetic-feed through. In case of an airlock loading solution, then the electrical connection is by a socket.

If the parabolic mirror occupies excessive solid angle such that normal SEM imaging techniques are overly impacted for the purposes of the experiment, then a cut away in certain locations may be employed.

The field of view in an SEM can be large because there are few restrictions to the beam path and no optical foci conditions to be met. For this technique the field of view and beam mapping magnification is limited by these conditions. For this reason, in an embodiment, the specimen is translated on the SEM stage without altering the Z height in order to study specimens over a wider area. The electron beam focus can be kept stationary with different parts of a specimen irradiated by translating the specimen on a stage independent of the mirror optics. For a flat specimen, this can be achieved without altering the focus of the device.

Using the described apparatus, experiments can be performed in conjunction with bandpass filtering and polarization filtering. For example the same region of interest can be probed on a specimen and alternative filters are employed to record the image.

The algorithm which turns the 2D image into an angular representation (Theta / Phi) is a known mathematical co-ordinate transformation such as is detailed in Ju Ren and Jianlin Zhao "Measurement of a bidirectional reflectance distribution and system achievement based on a hemi-parabolic mirror" Optics Letters 35, 1458 (2010).

In an embodiment where rotation of the specimen without impacting other variables is required, then a mechanism for eucentric rotation is used, wherein there is no movement of the region of interest in the X/Y plane. This can be achieved on an X/Y stage using automated corrective translation. If the specimen or stage is tilted with regard to the rotation axis, then correction of this tilt will be required. As the focus must remain constant, then eucentric tilt of the region of interest will be required.

To tilt the specimen, in a further embodiment, eucentric tilt about one or two axis may be provided. These eucentric tilt and rotation movements will provide a more flexible system. For example, in case the specimen emits luminescence of a certain polarization, then a second image of defined specimen rotation should provide confirmation of the result. With all other variables constant, the difference between two images recorded with the specimen rotated by a set degree will prove the lack of rotational symmetry in the emission of the specimen.

While the invention has been described in detail and with reference to specific examples thereof, it will be apparent to one skilled in the art that various changes and modifications can be made therein without departing from the spirit and scope thereof.

## Claims

1. A system for angular measurement of angular cathodoluminescence radiation patterns from a specimen in a charged particle microscope comprising:
a rotationally symmetric concave mirror having a rotational axis and a hole at the intersection of the rotational axis and the mirror;
a charged particle source, directing charged particles through said hole toward the specimen; and
an image sensor for recording a two-dimensional cathodoluminescence image;
wherein the specimen is located between said mirror and said sensor at the focal point of said mirror and the cathodoluminescence is directed by the mirror to the sensor and wherein
said two dimensional cathodoluminescence image maps to polar angles of radiation emission from the specimen.

2. The system of Claim 1, further comprising a filter placed between the sample and said sensor.

3. The system of Claim 2, wherein said filter is at least one of a spectral bandpass filter and an actuated polarizing filter

4. The system of Claim 1, wherein said mirror is inserted into the microscope by a remote fixing post attached to a chamber wall of the microscope.

5. The system of Claim 4, wherein said mirror is actuated by a linear actuator.

6. The system of Claim 1, wherein said mirror is parabolic.

7. The system of Claim 1, further comprising an eucentric rotation stage.

8. The system of Claim 1, further comprising an eucentric tilt stage.

9. A method of measuring angular distribution of radiated cathodoluminescence from a specimen in a charged particle microscope comprising:
providing a rotationally symmetric concave mirror having a rotational axis and a hole at the intersection of the rotational axis and the mirror;
locating the specimen at the focal point of said mirror between said mirror and a sensor for recording a two-dimensional cathodoluminescence image;
directing charged particles through said hole toward the specimen; and
relating said two dimensional cathodoluminescence image to polar angles of radiation emission from the specimen.
